Europäisches Patentamt

European Patent Office

Office européen des brevets

(11) Numéro de publication : **0 029 631**
**B1**

(12) **FASCICULE DE BREVET EUROPÉEN**

(45) Date de publication du fascicule du brevet :
04.07.84

(51) Int. Cl.³ : **B 61 L   1/20**, G 11 C  11/20

(21) Numéro de dépôt : **80201096.7**

(22) Date de dépôt : **20.11.80**

(54) **Mémoire électronique de sécurité utilisable en signalisation ferroviaire.**

(30) Priorité : **21.11.79 FR 7928720**

(43) Date de publication de la demande :
**03.06.81 Bulletin 81/22**

(45) Mention de la délivrance du brevet :
**04.07.84 Bulletin 84/27**

(84) Etats contractants désignés :
**BE CH DE FR GB IT LI NL SE**

(56) Documents cités :
**FR-A- 1 171 567
FR-A- 1 281 318
FR-A- 1 405 259**

(73) Titulaire : **SOCIETE D'OPTIQUE, DE MECANIQUE
D'ELECTRICITE ET DE RADIO O.M.E.R.A. - S.E.G.i.D.
49, rue Ferdinand Berthoud
F-95100 Argenteuil (FR)
FR
N.V. Philips' Gloeilampenfabrieken
Groenewoudseweg 1
NL-5621 BA Eindhoven (NL)
BE CH DE GB IT LI NL SE**

(72) Inventeur : **Forward, Bernard Edouard
SOCIETE CIVILE S.P.I.D. 209, rue de l'Université
F-75007 Paris (FR)**

(74) Mandataire : **Pyronnet, Jacques et al
Société Civile S.P.I.D. 209, rue de l'Université
F-75007 Paris (FR)**

Jouve, 18, rue St-Denis, 75001 Paris, France

**0 029 631**

**Description**

L'invention concerne une mémoire électronique de sécurité comportant d'une part une première entrée de tension d'alimentation continue, une deuxième entrée de commande et une sortie, d'autre part un oscillateur à transistor dont un enroulement primaire de transformateur connecté au collecteur réagit par l'intermédiaire dudit transformateur sur un premier enroulement secondaire relié à une autre électrode dudit transistor de façon à créer une boucle de réaction pour engendrer l'oscillation dont la fréquence est déterminée par un premier condensateur branché en parallèle sur ledit enroulement primaire, ladite mémoire étant remise à zéro par coupure de la tension d'alimentation.

Une telle mémoire de sécurité trouve sa principale application dans le domaine de la signalisation ferroviaire. Elle peut notamment être utilisée dans une boîte de traitement où elle fait partie d'un ensemble logique visant à la commande d'un relais d'utilisateur qui commande par exemple la fermeture d'un passage à niveau, à partir de signaux émis par les capteurs d'une pédale électronique lors du passage d'un train.

On connaît des mémoires électroniques telles que définies en préambule et visant ce genre d'applications. Une telle mémoire est décrite dans le brevet français n° 1 281 318. Elle doit être de sécurité au sens ferroviaire du terme, c'est-à-dire que toute panne ou défaut du montage électronique entraîne la disparition du signal de sortie de l'oscillateur. On ne peut donc pas obtenir, suite à une avarie, un signal plus permissif que l'état normal. La sortie de la mémoire est constituée par un signal de tension alternative. Lorsque l'oscillateur est à l'état débloqué, cette tension alternative est présente et l'on dira par convention que le contenu de la mémoire présente l'état logique « 1 », cet état logique étant « 0 » lorsque l'oscillateur est bloqué, la tension de sortie étant alors nulle. Une telle mémoire comporte deux entrées. L'entrée de tension d'alimentation sert à valider la mémoire, c'est-à-dire qu'en l'absence de la tension continue d'alimentation l'état de sortie est obligatoirement « 0 », cet état pouvant être « 1 » ou « 0 » lorsque la tension d'alimentation est présente. L'entrée de commande reçoit un signal qui est soit une tension continue soit une tension nulle ce signal de commande portant l'information à mémoriser. D'autre part une telle mémoire fonctionne en séquence, son état sortie pouvant être différent pour certains états des entrées identiques en fonction des états antérieurs des entrées et de leurs transitions. La mémoire selon le brevet français 1 281 318 est à commande positive, c'est-à-dire qu'elle mémorise l'apparition de la tension continue du signal de commande, en délivrant un signal de sortie égal à « 1 » lors de cette apparition, l'état « 1 » s'automaintenant ultérieurement quelle que soit alors la forme d'onde du signal de commande entre ses deux états possibles définis ci-dessus. La remise à zéro de la mémoire se fait ensuite par coupure de la tension d'alimentation sur la première entrée. La séquence logique à réaliser est indiquée au tableau 1 de la page 3 du brevet précité. La mémoire de l'art antérieur décrite ci-dessus est d'application lorsque le signal de commande est nul au repos et qu'il devient non nul lors de l'apparition d'un événement extérieur. Dans certains cas, cependant, il s'avère plus intéressant que l'apparition de cet événement extérieur s'accompagne de l'affaiblissement ou de la disparition d'un signal normalement présent. C'est ainsi que fonctionne par exemple une pédale négative orientée qui comporte deux capteurs électroniques disposés assez rapprochés sur une voie ferrée. Ces capteurs sont, au repos, alimentés en permanence en courant alternatif, chacun à une fréquence prédéterminée, par un oscillateur, ce qui va dans le sens de la sécurité. Ce signal alternatif dont l'amplitude dépasse un certain seuil se traduit au niveau d'une boîte de traitement, pour chaque capteur, par un signal de tension continue. Le signal de sortie de la boîte de traitement commande lui-même un relais. Lors du passage d'un essieu de véhicule ferroviaire devant chaque capteur, une variation inductive est créée dans ce dernier, qui a pour effet de rabaisser l'amplitude du signal alternatif, en dessous du seuil précité, ce qui, dans la boîte de traitement, se traduit par le passage à zéro dudit signal de tension continue. Il peut être utile, dans la boîte de traitement, de mémoriser la disparition de cette tension continue. Si l'on souhaite mémoriser cette transition négative à l'aide de la mémoire à commande positive de l'art antérieur, il faut alors lui adjoindre juste en amont un inverseur logique, ce qui complique le schéma électronique et augmente le risque de panne, d'autant plus que cet inverseur logique doit être lui-même de sécurité au sens ferroviaire du terme, ce qui accroît sa complexité par rapport à un inverseur logique ordinaire. En pratique, ce n'est pas directement l'état du capteur dont on souhaite mémoriser le changement, dans la boîte de traitement, mais l'apparition ou la disparition d'une fonction logique de plusieurs variables logiques parmi lesquelles peuvent être incluses par exemple l'occultation ou la non occultation des capteurs pour reprendre l'exemple de la pédale négative orientée. Selon le cas il sera plus avantageux, dans le but de minimiser le nombre de composants, d'utiliser soit la fonction logique elle-même, soit son complément, étant donné l'état des variables logiques séparées qui sont à disposition à l'intérieur de l'ensemble du dispositif logique de la boîte de traitement. Ceci signifie que dans certains cas la mémoire de sécurité de l'art antérieur n'est pas adaptée au mieux à la fonction logique à mémoriser.

L'invention se propose de résoudre les inconvénients précités de l'art antérieur. Dans ce but, la mémoire électronique de sécurité définie dans le préambule est remarquable en ce que, selon l'invention, elle est à commande négative et qu'à cet effet elle comporte les caractéristiques de la partie caractérisante de la revendication 1.

Dans le cas d'une fonction logique de plusieurs variables à mémoriser, il peut être plus avantageux

2

d'utiliser une telle mémoire à commande négative qui reçoit sur son entrée de commande le complément de la fonction logique considérée plutôt qu'une mémoire à commande positive de l'art antérieur qui recevrait sur son entrée la fonction logique elle-même, dans la mesure où le complément de cette fonction logique est plus facile à obtenir que la fonction elle-même.

La description suivante en regard du dessin annexé, le tout donné à titre d'exemple, fera bien comprendre comment l'invention peut être réalisée.

La figure unique est un schéma électronique d'une mémoire de sécurité selon l'invention, utilisant un oscillateur à transistor monté en émetteur commun.

La mémoire 1 de la figure comporte une première entrée de tension d'alimentation reliée à la borne d'entrée 2. Cette borne est reliée par l'intermédiaire d'un interrupteur 3 à une borne 4 qui reçoit en permanence une tension continue d'alimentation $V_{cc}$, sauf coupure accidentelle, en amont, de cette tension. L'interrupteur 3 est par exemple commandé par un relais, non représenté, ce relais pouvant être le relais d'utilisateur commandé par la sortie d'une boîte de traitement non représentée dont fait partie la mémoire 1. Une deuxième entrée de commande est reliée à la borne d'entrée 5. Une sortie connectée entre les bornes 6 et 7 délivre un signal qui peut être soit un signal de tension alternative, ce qui constitue la valeur logique « 1 » soit un signal de tension nulle, ce qui constitue la valeur logique « 0 ».

La partie essentielle de la mémoire est constituée par un oscillateur comportant un transistor 8 dont le collecteur est relié à un conducteur 9, par l'intermédiaire du montage en parallèle d'une self 10 et d'un condensateur 11. Le collecteur est aussi relié à la borne 5 par l'intermédiaire d'une diode 12 montée en inverse. L'émetteur du transistor 8 est relié au conducteur de masse 13 par l'intermédiaire d'une self 14. La base du transistor est reliée au conducteur 9 par l'intermédiaire de la résistance 15 et à la masse par l'intermédiaire de la résistance 16, ces deux résistances servant à sa polarisation.

La self 10 constitue l'enroulement primaire d'un transformateur 17 dont un enroulement secondaire est constitué par la self 14. Lorsque le conducteur 9 reçoit une tension continue d'alimentation positive, l'ensemble comportant les éléments 9 à 11 et 13 à 17, abstraction faite de l'entrée 5 et de la diode 12, constitue un oscillateur à transistor, à réaction parallèle-série, le transistor étant monté en émetteur commun. Il convient de préciser que pour obtenir une réaction créant l'oscillation et non une contre réaction, les enroulements 10 et 14 doivent être de même sens et que le nombre de spires de l'enroulement primaire 10 est de l'ordre de 10 fois supérieur à celui de l'enroulement secondaire 14. La fréquence d'oscillation est déterminée par les valeurs $L_{10}$ et $C_{11}$ de l'inductance et de la capacité des éléments 10 et 11 respectivement. Un tel oscillateur fonctionne correctement pour une gamme de fréquences comprises de préférence entre 1 et 10 kHz.

En plus de l'oscillateur proprement dit décrit ci-dessus la mémoire de sécurité selon l'invention comporte un amplificateur 18 qui est alimenté entre la borne 2 et la masse. Son entrée est reliée à la masse par l'intermédiaire d'une self 19 qui constitue un deuxième enroulement secondaire du transformateur 17. Sa sortie délivre, lorsque l'oscillateur fonctionne, un signal carré à la fréquence d'oscillation dans un enroulement primaire 20 d'un deuxième transformateur 21, l'enroulement 20 étant relié à la masse par son autre extrémité. Le transformateur 21 a deux secondaires qui sont l'enroulement 22 dont les extrémités sont reliées aux bornes de sortie 6 et 7 et l'enroulement 23 dont une extrémité est reliée à la masse et l'autre à une électrode (par exemple l'anode) d'une diode 24. L'autre électrode de la diode 24 est reliée au point de connexion 25 qui appartient au conducteur 9 et qui est relié, par l'intermédiaire d'un condensateur 26, à la masse. Le montage constitué par la diode 24 et le condensateur 26 sert au redressement du courant alternatif dont l'enroulement 23 est le siège lorsque l'oscillateur fonctionne. Grâce à l'apport d'énergie dû à l'amplificateur 18, l'ensemble du dispositif est à même de s'automaintenir en état d'oscillation en compensant ses pertes, le condensateur 26 faisant alors office de batterie. Afin de ne pas perturber ce circuit de redressement de tension, et d'obtenir une isolation galvanique, la sortie du dispositif est prise sur l'enroulement secondaire séparé, 22, du transformateur 21. Il faut noter que l'amplificateur 18 étant alimenté, c'est-à-dire l'interrupteur 3 étant fermé, l'oscillateur reste bloqué tant que la tension aux bornes du condensateur 25 reste voisine de zéro et qu'il ne peut pas se débloquer de lui-même. Par contre, étant donnée la polarisation des diodes 12 et 24 indiquée sur la figure, une tension positive de quelques volts au point 25 suffit à le faire démarrer, même si cette tension positive est inférieure à la tension d'alimentation $V_{cc}$. Dans ce dernier cas, il se produit un régime transitoire pendant lequel la tension continue au point 25 croît jusqu'à atteindre une valeur sensiblement égale à la tension d'alimentation $V_{cc}$ à laquelle elle se stabilise pendant tout le temps de fonctionnement de l'oscillateur.

La tension sur la borne d'entrée 5 peut prendre la valeur par exemple positive $V_c$ telle que : $V_c < V_{cc}$, ou la valeur nulle, valeurs auxquelles on associe par convention les valeurs logiques « 1 » et « 0 » respectivement pour faciliter le raisonnement. De même, on fait correspondre à la tension par exemple positive $V_{cc}$ et à la tension nulle sur la borne d'entrée d'alimentation 2 les états logiques « 1 » et « 0 » respectivement. Dans ces conditions, on désire, selon l'invention, mémoriser la disparition de la tension $V_c$, c'est-à-dire débloquer l'oscillateur, ce dernier devant s'automaintenir après cet événement, quelles que soient les transitions ultérieures du signal sur la borne 5 d'une part et ce déblocage suivi d'un automaintien de l'oscillateur ne pouvant être dû qu'à cette transition d'autre part, c'est-à-dire impossible à obtenir à la suite d'une séquence différente sur les entrées 2 et 5 ou à la suite d'un défaut quelconque du circuit électronique décrit ci-dessus.

# 0 029 631

On décrit en premier lieu ci-dessous la façon dont est réalisé le déblocage de l'oscillateur, lors d'une transition entre les états logiques « 1 » et « 0 » de la commande, et son automaintien en oscillation.

La mémoire fonctionnant en séquence, on part par exemple d'une phase de repos dite première phase de mise à zéro pour laquelle les entrées 2 et 5 sont toutes deux à l'état logique « 0 ». Elle délivre alors à sa sortie un état logique « 0 », l'amplificateur 18 n'étant pas alimenté. On arme ensuite la mémoire en faisant passer l'entrée 2 à l'état « 1 », l'entrée 5 étant toujours à l'état « 0 », c'est-à-dire en fermant l'interrupteur 3. Dans cette deuxième phase d'armement la mémoire délivre toujours un « 0 » puisque le condensateur 26 n'est pas chargé. Puis on passe à une troisième phase en faisant passer l'entré 5 de « 0 » à « 1 ». Lors de cette transition le condensateur 26 se charge presque à la tension $V_c$ par l'intermédiaire de la diode 12 dans le sens passant, de l'enroulement 10 et du conducteur 9 (à la chute de tension à travers la diode 12 près, qui est négligeable). Lors de cette troisième phase, l'oscillateur reste toujours bloqué (tension nulle en sortie de la mémoire) car bien que le condensateur 26 soit chargé à une tension correcte pour engendrer l'oscillation, cette dernière ne peut pas s'amorcer, le collecteur du transistor 8 étant polarisé à une tension trop basse par rapport à sa base (après un régime transitoire les potentiels du collecteur et du conducteur 9 sont sensiblement égaux). Le passage à une quatrième phase consiste, en partant de la troisième phase, à supprimer la tension de commande $V_c$, ce qui a pour résultat de débloquer l'oscillateur qui amorce son oscillation à partir de la tension $V_c$ du condensateur 26 puis, tout en continuant d'osciller fait croître la tension de ce dernier jusqu'à la valeur $V_{cc}$. Si la tension de commande est rétablie sur la borne d'entrée 5, ce qui constitue une cinquième phase, cela ne peut pas affecter le fonctionnement de l'oscillateur puisque la tension sur le collecteur du transistor 8 est alors supérieure à la tension $V_c$ en vertu de l'inégalité $V_c < V_{cc}$, les valeurs respectives de $V_c$ et de $V_{cc}$ étant judicieusement choisies, et que la diode 12 se trouve polarisée en inverse lors de ce cinquième état. L'arrêt de l'oscillateur, soit la remise à zéro de la mémoire, ne peut ensuite être obtenu que par coupure de la tension d'alimentation (ouverture de l'interrupteur 3) quel que soit l'état logique sur l'entrée 5. La séquence logique décrite ci-dessus que l'on souhaite obtenir en fonctionnement normal de la mémoire est résumée dans le tableau I ci-dessous :

Tableau I

| Etat logique de l'entrée d'alimentation | Etat logique de l'entrée de commande | Etat logique de la sortie |
|:---:|:---:|:---:|
| "0" | "0" | "0" |
| "1" | "0" | "0" |
| "1" | "1" | "0" |
| "1" | "0" | "1" |
| "1" | "1" | "1" |
| "0" | "1" | "0" |
| "0" | "0" | "0" |

L'homme du métier est à même de vérifier qu'aucune autre séquence n'existe, par action sur les valeurs logiques d'entrée, qui puisse provoquer le démarrage et l'automaintien de l'oscillateur, c'est-à-dire mémoriser autre chose qu'un front descendant sur l'entrée de commande 5, moyennant que le condensateur 26 n'ait pas une fonction de temporisation, c'est-à-dire que sa capacité soit de faible valeur.

De même, comme peut s'en assurer l'homme du métier, le circuit décrit ci-dessus a été conçu de façon telle que la défection de n'importe quel composant du circuit ne puisse provoquer intempestivement cette mémorisation, c'est-à-dire que toute défection entraîne l'impossibilité du fonctionnement de l'oscillateur. Par défection, on entend :

— coupure d'une résistance (seule envisagée étant donné le type de résistance choisi en sécurité ferroviaire),

— court-circuit ou coupure d'un condensateur ou d'une diode,

— coupure d'un enroulement ou court-circuit entre bornes d'enroulement d'un même transformateur,

— coupure d'une électrode du transistor, court-circuit ou courant de fuite entre deux électrodes du transistor.

Deux pannes simultanées ne sont pas envisagées, étant supposé qu'une panne est détectée avant qu'une autre ne survienne.

4

Par exemple si la diode 12 est coupée, le condensateur 26 ne pourra pas se charger ce qui mettra l'oscillateur dans l'impossibilité de fonctionner. Si elle est court-circuitée la cinquième phase décrite ci-dessus ne pourra plus être assurée puisque le retour de la tension $V_c$ sur la borne d'entrée 5 provoquera l'arrêt de l'oscillateur en polarisant son collecteur à la tension $V_c$.

A titre d'exemple non limitatif on indique ci-dessous quelques valeurs possibles pour certains composants d'un mode de réalisation de la mémoire de sécurité selon l'invention.

Enroulement 10 : 400 spires ; inductance de 100 mH

Condensateur 11 : capacité de 10 nF

Fréquence de fonctionnement de l'oscillateur : 5 kHz

Enroulement 14 : 30 spires.

Si l'on reprend la principale application, envisagée ci-dessus, à une pédale négative orientée, on peut, sans décrire l'ensemble du dispositif ni les principales fonctions logiques à réaliser, donner les précisions suivantes qui sont relatives à la mémoire de sécurité selon l'invention.

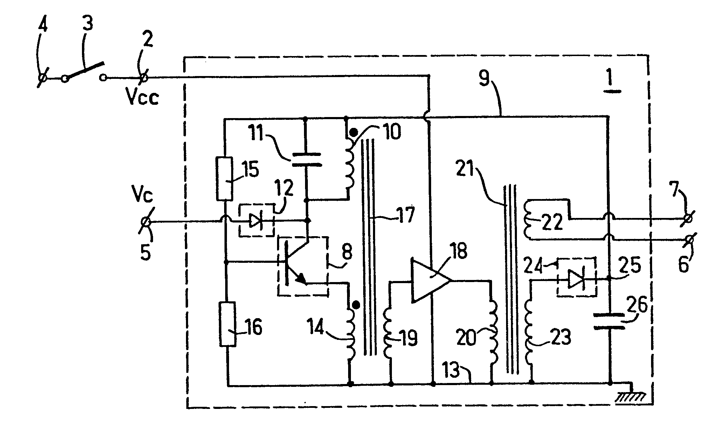

— Le relais d'utilisateur est à contact repos, c'est-à-dire qu'il est excité en permanence en l'absence de circulation sur la voie. Dans ces conditions, le contact 3 est ouvert, tel que représentation à la figure 1.

— La chute du relais, commandée par le signal de sortie de la boîte de traitement, provoque la fermeture de l'interrupteur 3, c'est-à-dire l'armement de la mémoire.

— La chute du relais peut être provoquée de façon intempestive (panne d'un composant ou signal non prévu par influence inhabituelle au niveau des capteurs). En fonctionnement normal (passage d'un train) la chute du relais est provoquée par l'action d'une chaîne logique annexe dont l'état dépend de celui des capteurs, combinée avec l'état de sortie « 0 » de la mémoire de sécurité.

— Le relais ne peut être réalimenté, après sa chute, que si la mémoire de sécurité a fonctionné, c'est-à-dire que si la disparition d'une fonction logique de plusieurs variables logiques caractéristiques du passage d'un train a été enregistrée et mémorisée.

Pour certaines applications de la mémoire de sécurité selon l'invention, il peut être nécessaire de mémoriser une disparition de la tension $V_c$ un très court instant avant que la tension d'alimentation $V_{cc}$ n'apparaisse. Par exemple, il peut être souhaitable que la disparition de la tension de commande $V_c$ entraîne indirectement l'apparition de la tension d'alimentation $V_{cc}$, par fermeture de l'interrupteur 3 consécutive à la chute d'un relais. Un temps de retard prédéterminé $\tau$ de l'ordre de quelques dixièmes de secondes s'écoule alors entre la disparition de la tension $V_c$ sur la borne d'entrée 5 et l'apparition de la tension $V_{cc}$ sur la borne d'entrée 2. Selon un deuxième mode de réalisation de l'intension, il est encore possible de mémoriser la disparition de la tension $V_c$, dans ces conditions, en donnant au condensateur 26 une fonction de temporisation. A cet effet, le schéma de la mémoire étant toujours celui de la figure 1 pour ce deuxième mode de réalisation, le condensateur 26 a une capacité accrue telle qu'après le temps $\tau$, il est encore en état de faire fonctionner l'oscillateur, c'est-à-dire à l'instant où la tension d'alimentation $V_{cc}$ apparaît et permet le maintien de l'oscillation. Le tableau II ci-dessous résume la séquence logique qu'il est possible d'obtenir, la séquence donnée dans le tableau I ci-dessus restant toujours possible :

Tableau II

| Etat logique de l'entrée d'alimentation | Etat logique de l'entrée de commande | Etat logique de la sortie |
|:---:|:---:|:---:|
| "0" | "0" | "0" |
| "0" | "1" | "0" |
| "0" | "0" | "0" |
| "1" | "0" | "1" |
| "1" | "1" | "1" |
| "0" | "1" | "0" |
| "0" | "0" | "0" |

Dans le tableau II, le temps qui s'écoule entre la deuxième et la troisième transition (passage de « 1 » à « 0 » de l'entrée de commande et passage de « 0 » à « 1 » de l'entrée d'alimentation respectivement) est égal à $\tau$.

Pour un fonctionnement correct de ce deuxième mode de réalisation, il faut éviter de donner au condensateur 26 une capacité trop élevée qui rendrait son temps de charge trop long. Il faut en effet que

5

le condensateur 26 ait le temps de se charger pendant l'intervalle de temps où la tension $V_c$ est présente sur la borne d'entrée 5.

Selon un troisième mode de réalisation qui se déduit du schéma de la figure, la mémoire de sécurité selon l'invention est à alimentation négative : les tensions $V_c$ et $V_{cc}$ ont des valeurs négatives, $V_{cc}$ ont des valeurs négatives, $V_{cc}$ étant plus grande, en valeur absolue que $V_c$, le transistor 8 est alors un transistor PNP, les connexions des électrodes restant les mêmes que ce qui est indiqué pour le transistor NPN de la figure et les diodes 12 et 14 sont montées en sens inverse du sens indiqué sur la figure, toutes choses restant égales par ailleurs sur le schéma de la figure unique.

## Revendications

1. Mémoire électronique de sécurité (1) comportant d'une part une première entrée de tension d'alimentation continue (4), une deuxième entrée de commande (5) et une sortie (6, 7) délivrant un signal de tension alternative ou nulle, d'autre part un oscillateur à transistor dont un enroulement primaire de transformateur (10) connecté par une première extrémité au collecteur réagit par l'intermédiaire dudit transformateur (17) sur un premier enroulement secondaire (14) relié à une autre électrode dudit transistor (8) de façon à créer une boucle de réaction pour engendrer l'oscillation dont la fréquence est déterminée par un premier condensateur (11) branché en parallèle sur ledit enroulement primaire, ladite mémoire étant remise à zéro par coupure de la tension d'alimentation, caractérisée en ce qu'elle est à commande négative, et qu'à cet effet elle comporte en outre un amplificateur de puissance (18) qui reçoit ladite première entrée de tension d'alimentation, dont la tension d'entrée est fournie par un deuxième enroulement secondaire (19) dudit transformateur, et qui comporte, par l'intermédiaire d'un deuxième transformateur (21), deux sorties, d'une part une sortie de courant continu fournie à un deuxième condensateur (26) connecté entre la masse (13) et la deuxième extrémité dudit enroulement primaire (10), dont la charge sert de source d'alimentation pour l'oscillateur et dont la tension de charge, lors du fonctionnement dudit oscillateur, est sensiblement égale à ladite tension d'alimentation et permet l'entretien de ladite oscillation, d'autre part une deuxième sortie de courant alternatif qui constitue ladite sortie de la mémoire, ladite deuxième entrée de commande étant reliée par l'intermédiaire d'une diode (12) au collecteur dudit transistor, ladite diode étant reliée dans le sens direct si les tensions de commande et d'alimentation sont positives ledit transistor étant du type NPN ou dans le sens inverse si les tensions de commande et d'alimentation sont négatives ledit transistor étant du type PNP, ladite entrée de commande fournissant un signal de tension de commande continue de valeur absolue inférieure à la valeur absolue de la tension d'alimentation, ledit signal étant susceptible de bloquer ledit oscillateur lorsqu'il est présent, sa disparition provoquant le déblocage de l'oscillateur de façon irréversible relativement à ses transitions ultérieures, alors que ladite tension d'alimentation est présente avant la disparition dudit signal de commande ou un temps de retard prédéterminé court après ladite disparition.

2. Mémoire électronique de sécurité selon la revendication 1, dans laquelle ledit premier enroulement secondaire (14) est relié à l'émetteur dudit transistor, ledit enroulement primaire (10) étant de même sens que ledit premier enroulement secondaire (14), la base dudit transistor (8) étant reliée au point commun de deux résistances de polarisation (15, 16) disposées en série aux bornes dudit deuxième condensateur (26).

3. Application de la mémoire électronique de sécurité selon la revendication 1 ou 2 à la signalisation ferroviaire, notamment à l'enregistrement et la mémorisation de la disparition d'une fonction logique de plusieurs variables logiques prédéterminée dans la boîte de traitement d'une pédale négative orientée.

## Claims

1. An electronic security memory (1) comprising a first input (4) for a d.c. supply voltage, a second input (5) for a control signal, and an output (6, 7) which supplies an a.c. or zero signal, as well as a transistor oscillator, feedback being provided via a transformer from a primary winding (10) of said transformer (17) to a first secondary winding (14), the primary winding being connected to the collector and the first secondary winding being connected to another electrode of the said transistor (8), in such a way that a feedback loop is formed in order to produce an oscillation whose frequency is determined by a first capacitor (11) which is connected in parallel with said primary winding, said memory being reset to zero by interruption of the supply voltage, characterized in that the memory is of the negative-control type and for this purpose also comprises a power amplifier (18) which is powered via said first input, whose input voltage is supplied by a second secondary winding (19) of said transformer, and which comprises two outputs via a second transformer (21), one output for a direct current which is supplied to a second capacitor (6) which is connected to earth (13) and to the second terminal of said primary winding (10), whose charge serves as power-supply for the oscillator, and whose, charging voltage, during operation of said oscillator is substantially equal to said supply voltage and enables said oscillation to be sustained, and a second, alternating current output which contitutes said output of the memory, said second input being connected to the collector of said transistor via a diode (12), said diode being poled in the forward direction if the control and supply voltages are positive, with said transistor being of the NPN-type, or said diode being poled in the reverse direction if the control and supply voltages are negative, with said transistor being of the PNP-type, said second input supplying a d.c. control voltage having a value which is smaller than the absolute value of the said supply voltage, said control voltage being capable of blocking said oscillator during its presence, its disappearance causing the oscillator to be unblocked irreversibly with respect to subsequent transitions, whilst said supply voltage is present before the disappearance of said control signal or a short predetermined delay time after said disappearance.

2. An electronic security memory as claimed in Claim 1, in which said first secondary winding (14) is connected to the emitter of said transistor, said primary winding (10) having the same winding direction as said first secondary winding (14), the base of said transistor (8) being connected to the junction point of two bias resistors (15, 16) which are connected in series across said second capacitor (26).

3. An electronic security memory as claimed in Claim 1 or 2, used for railway signalling, specifically for detecting and storing the disappearance of a specific logic function of a plurality of logic variables in the processing unit of a negative directional treadle.

## Ansprüche

1. Elektronischer Sicherheitsspeicher (1) mit einerseits einem Gleichspannungs-Speiseeingang (4), einem Steuereingag (5) und einem ein Wechselspannungs- oder Nullspannungssignal liefernden Ausgang (6, 7), andererseits einem Transistoroszillator, der über eine mit ihrem ersten Anschluss an den Kollektor angeschlossene Primärwicklung (10) eines Transformators, mit Hilfe dieses Transformators (17) mit einer ersten, mit einer anderen Elektrode des Transistors (8) verbundenen Sekundärwicklung (14) derart zusammenwirkt, dass eine Rückkopplungsschleife zum Erzeugen einer Schwingung gebildet wird, deren, Frequenz durch einen ersten, parallel zur Primärwicklung geschalteten Kondensator (11) bestimmt wird, wobei der Speicher durch Unterbrechung der Speisespannung auf Null gestellt wird, dadurch gekennzeichnet, dass der Speicher negativ angesteuert wird und dass er zu diesem Zweck ausserdem einen Leistungsverstärker (18) enthält, der mit dem ersten Gleichspannungs-Speiseeingang verbunden ist, dessen Eigangsspannung von einer zweiten Sekundärwicklung (19) des erwähnten Transformators geliefert wird, und der mittels eines zweiten Transformators (21) zwei Ausgänge enthält, einerseits einen Gleichstromausgang, der aus einem zweiten Kondensator (26) gespeist wird, der zwischen Masse (13) und dem zweiten Anschluss der erwähnten Primärwicklung (10) angeschlossen ist, dessen Ladung als Speisequelle für den Oszillator dient und dessen Ladungsspannung durch die Wirkung des Oszillators genau gleich der Speisespannung ist und die Aufrechterhaltung der Schwingung ermöglicht, andererseits einen Wechselspannungsausgang, der den Speicherausgang bildet, dass der Steuereingang über eine Diode (12) mit dem Kollektor des Transistors verbunden ist, wobei die Diode direkt verbunden ist, wenn die Steur- und Speisespannungen positiv und der Transistor vom npn-Typ sind, oder umgekehrt angeschlossen ist, wenn die Steuer- und Speisespannungen negativ und der Transistor vom pnp-Typ sind, dass der Steuereingang ein Gleichspannungs-Steuersignal liefert, dessen absoluter Wert kleiner als der absolute Wert der Speisespannung ist und das — wenn es vorhanden ist — den Oszillator sperren kann, und das Verschwinden der Schwingung die Freigabe des Oszillators unumkehrbar in bezug auf seine letzten Übergänge auslöst, und dass die Speisespannung vor dem Verschwinden des erwähnten Steuersignals oder eine vorgegebene kurze Verzögerungszeit nach diesem Verschwinden vorhanden ist.

2. Elektronischer Sicherheitsspeicher nach Anspruch 1, dadurch gekennzeichnet, dass die erste Sekundärwicklung (14) mit dem Emitter des Transistors verbunden ist, dass die Primärwicklung (10) die gleiche Wickelrichtung hat die erste Sekundärwicklung (14), und dass die Basis des Transistors (8) mit dem Verbindungspunkt von zwei zwischen die Anschlüsse des zweiten Kondensators (26) in Serie geschalteten Vorspannungswiderständen (15, 16) verbunden ist.

3. Verwendung des elektronischen Sicherheitsspeichers nach Anspruch 1 oder 2 für Eisenbahnsignalisierung, insbesondere für die Detektion und die Speicherung des Verschwindens einer logischen Funktion einer Vielzahl logischer Variablen, welche Funktion in der Betriebseinheit eines gerichteten negativen Schienenkontakts vorgesehen ist.

0 029 631